# EUROPEAN PATENT APPLICATION

(11) **EP 4 525 226 A1**
(43) Date of publication of application: **19.03.2025**
(21) Application number: 24191461.3
(22) Date of filing: 29.07.2024
(51) Int. Cl.: H01S 5/14, H01S 3/08, H01S 3/105, H01S 5/10, H01S 3/08022, H01S 3/106, H01S 5/024, H01S 5/06

(54) **LASER WITH TUNABLE REFLECTOR**

(30) Priority: 14.09.2023 US 202363538487 P
(71) Applicant: Marvell Asia Pte Ltd, Singapore 369522 (SG)
(72) Inventor: He, Xiaoguang, Diamond Bar, CA 91765 (US); Nagarajan, Radhakrishnan, 369522 Singapore (SG)
(74) Representative: Grünecker Patent- und Rechtsanwälte PartG mbB

(57) **Abstract**

An optoelectronic device includes a gain medium having first and second ends and configured to amplify laser radiation within a gain band having a peak at a given wavelength. A laser cavity, containing the gain medium, includes a first reflector disposed on a first side of the gain medium and a second reflector disposed on a second side of the gain medium, opposite the first side. The second reflector has a reflectance as a function of wavelength that is tunable so as to reduce a reflectance of the second reflector at the peak of the gain band, thereby broadening a spectrum of the laser radiation emitted from the gain medium through the second reflector.

## Description

### CROSS-REFERENCE TO RELATED APPLICATION

This application claims the benefit of U.S. Provisional Patent Application 63/538,487, filed September 14, 2023, which is incorporated herein by reference.

### FIELD

The present invention relates generally to optoelectronic devices, and particularly to semiconductor lasers.

### BACKGROUND

Wavelength domain multiplexing (WDM) is used in high-speed optical communications to enable multiple communication signals with different carrier wavelengths to be transmitted over the same optical fiber. Some WDM devices use a single laser, emitting radiation at a comb of wavelengths, to provide carrier waves at multiple wavelengths simultaneously. The term "comb," as used in the present description and in the claims, refers to a set of distinct spectral lines, which are spaced apart by equal steps in wavelength. The term "comb filter" refers to an optical filter having a passband consisting of such a comb, such that the comb filter passes light having a wavelength in the set of distinct spectral lines while blocking wavelengths between the lines in the set.

The terms "light" and "optical radiation" are used synonymously in the present description and in the claims to refer to electromagnetic radiation in any of the infrared, visible, and ultraviolet spectral ranges.

Mach-Zehnder interferometers (MZIs) are used in a variety of silicon photonics applications. For example, El Shamy et al. describe a tunable filter based on an MZI in "Modelling, characterization, and applications of silicon on insulator loop terminated asymmetric Mach Zehnder interferometer," Scientific Reports 12:3598 (2022). The authors describe a loop-terminated MZI whose spectrum can be tuned not only by controlling the phase difference between the interferometer arms, but also by using its directional couplers coefficients, forming a spectral tunable filter.

### SUMMARY

Embodiments of the present invention that are described hereinbelow provide semiconductor laser devices that output optical radiation over a range of wavelengths, as well as methods for producing and operating such devices.

There is therefore provided, in accordance with an embodiment of the invention, an optoelectronic device, including a gain medium having first and second ends and configured to amplify laser radiation within a gain band having a peak at a given wavelength. A laser cavity contains the gain medium and includes a first reflector disposed on a first side of the gain medium and a second reflector disposed on a second side of the gain medium, opposite the first side. The second reflector has a reflectance as a function of wavelength that is tunable so as to reduce a reflectance of the second reflector at the peak of the gain band, thereby broadening a spectrum of the laser radiation emitted from the gain medium through the second reflector.

In a disclosed embodiment, the device includes a bandpass filter disposed within the laser cavity and having a passband encompassing the peak of the gain band.

Additionally or alternatively, the device includes a comb filter disposed within the laser cavity and configured to pass a set of distinct wavelength sub-bands within the gain band, the set of distinct wavelength sub-bands defining a comb, wherein tuning the second reflector to reduce the reflectance increases a number of the wavelength sub-bands in the laser radiation that is emitted from the gain medium. In a disclosed embodiment, the comb filter includes an optical ring resonator.

In some embodiments, the second reflector includes a tunable Mach-Zehnder interferometer (MZI). In a disclosed embodiment, the tunable MZI includes a pair of waveguides disposed on a substrate and a heater disposed on the substrate and coupled to vary a temperature of at least one of the waveguides.

Additionally or alternatively, the gain medium and the first reflector are together included in a reflective semiconductor optical amplifier (RSOA), and the second reflector is included in an external laser cavity, which is disposed on an optical substrate and is optically coupled to the RSOA. In one embodiment, the RSOA includes a III-V semiconductor material, and the external laser cavity includes a silicon photonic integrated circuit (PIC).

There is also provided, in accordance with an embodiment of the invention, a method for generating radiation. The method includes providing a gain medium having first and second ends and configured to amplify laser radiation within a gain band having a peak at a given wavelength. The gain medium is inserted in a laser cavity including a first reflector disposed on a first side of the gain medium and a second reflector disposed on a second side of the gain medium, opposite the first side, the second reflector having a reflectance that is tunable as a function of wavelength. The second reflector is tuned so as to reduce the reflectance at the peak of the gain band, thereby broadening a spectrum of the laser radiation emitted from the gain medium through the second reflector.

The present invention will be more fully understood from the following detailed description of the embodiments thereof, taken together with the drawings in which:

### BRIEF DESCRIPTION OF THE DRAWINGS

Fig. 1 is a block diagram that schematically illustrates a multi-wavelength laser device, in accordance with an embodiment of the invention;
Fig. 2A is a schematic detail view of a tunable reflector used in the device of Fig. 1, in accordance with an embodiment of the invention;
Fig. 2B is a schematic plot of the reflectivity of the tunable reflector of Fig. 2A;
Fig. 3 is a plot that schematically shows spectral characteristics of the laser device of Fig. 1, in accordance with an embodiment of the invention;
Figs. 4 and 5 are plots that schematically illustrate tuning of the spectral characteristics of the laser device of Fig. 1, in accordance with an embodiment of the invention; and
Fig. 6 is a plot that schematically shows an output spectrum of the laser device of Fig. 1, in accordance with an embodiment of the invention.

### DETAILED DESCRIPTION

Some multi-wavelength semiconductor lasers that are used in WDM applications emit a comb of wavelength sub-bands extending over a certain spectral range. The density of the comb (i.e., the spacing between center wavelengths of the sub-bands) is determined by the laser cavity length, while the spectral range is limited mainly by the width of the gain band of the optical gain medium in the laser. The gain band typically has a peak at a certain wavelength and falls off sharply on either side of the peak. The gain medium is contained in a laser cavity, comprising reflectors on opposing sides of the gain medium, along with a comb filter within or outside the laser cavity.

To increase the information-carrying capacity of a WDM communication link, it is desirable that the laser driving the link emit a broad comb with many wavelengths, with roughly equal output powers in all the wavelengths of the comb. For this purpose, in embodiments of the present invention, the output reflector of the laser cavity containing the gain medium has a spectral reflectance (i.e., varying reflectance as a function of wavelength) that is tunable. The output reflector is tuned to reduce its reflectance at the peak of the gain band, thereby broadening the spectrum of the laser radiation emitted from the gain medium through the second reflector.

The broadened spectrum enables the laser device to output a comb that includes a larger number of wavelength sub-bands for a given spacing between the sub-bands. Alternatively, the principles of the present invention may be applied to broaden the spectral output bands of lasers of other types, not only comb lasers. In either case, tuning of the spectral reflectance of the output reflector creates a broad, flat laser output spectrum without compromising the efficiency of the laser, since the power output capability of the gain medium is fully utilized, i.e., the added loss at the peak of the gain band translates into increased laser power output in the wings of the gain band.

In some embodiments, the output reflector comprises a tunable Mach-Zehnder interferometer (MZI), comprising a pair of waveguides disposed on a substrate, such as a photonic integrated circuit (PIC). A heater on the substrate is driven to vary the temperature of one or both of the waveguides and thus adjust their relative optical lengths. The resulting phase difference of the radiation propagating in the two waveguides determines the fraction of energy that is output through the reflector as a function of wavelength. The spectral reflectance is tuned by controlling the temperature of the heater. Alternatively, other sorts of broadband tunable optical elements can be used to control the spectral reflectance of the output reflector.

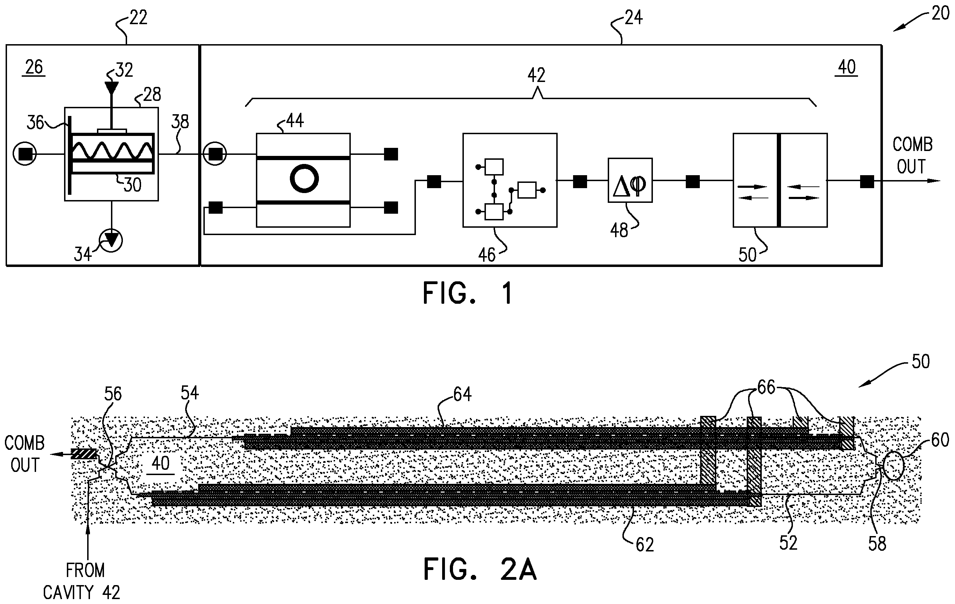

Fig. 1 is a block diagram that schematically illustrates a multi-wavelength laser device 20, in accordance with an embodiment of the invention. Device 20 comprises an active optical chip 22 on a III-V semiconductor substrate 26, such as GaAs or InP, and a PIC 24 on an optical substrate 40, for example a silicon-on-insulator (SOI) substrate. For mechanical stability and compact packaging, chip 22 may be bonded to optical substrate 40, for example using a suitable adhesive. Alternatively, chip 22 and PIC 24 may be mounted separately and connected, for example, by a suitable optical fiber.

Chip 22 comprises a reflective semiconductor optical amplifier (RSOA) 28, comprising an optical gain medium 30, which amplifies laser radiation within a certain gain band, and a reflector 36 formed at the inner end of gain medium 30. Application of a drive voltage between electrodes 32 and 34 on chip 22 gives rise to optical gain in medium 30 across the gain band, for example over a band of several tens of nanometers centered at a peak at around 1310 nm or 1550 nm depending on the type of gain medium that is used. Gain medium 30 may comprise, for example, GaInAsP, AlGaInAs quantum wells, or InAs quantum dots, which emit light in these gain bands. Reflector 36 may comprise a distributed Bragg reflector (DBR), for example, or a reflective coating on the rear facet of the RSOA. A waveguide 38 on substrate 26 conveys laser radiation into and out of the RSOA at the end opposite reflector 36.

PIC 24 comprises an external laser cavity 42, which is optically coupled to waveguide 38 and terminates in a tunable reflector 50. Reflector 50 is partially reflecting, to allow the multi-wavelength laser beam that is generated by device 20 to exit from the cavity, and has a reflectance as a function of wavelength that is tunable. Specifically, in the present embodiment, reflector 50 is tuned to reduce its reflectance at the peak of the gain band of gain medium 30. This functionality of reflector 50 is described in greater detail hereinbelow.

Cavity 42 contains a comb filter 44 and a bandpass filter 46 in series, along with a phase tuner 48 for adjusting the cavity phase. Comb filter 44 in this example comprises an optical ring resonator, with a ring length chosen so that filter 44 passes a comb of wavelength sub-bands within the gain band of RSOA 28. Thus, multi-wavelength laser device 20 can serve as a beam source for WDM communication applications, for example, with the wavelength spacing between the sub-bands in the comb set equal to the spacing between the WDM channels. Bandpass filter 46 has a passband encompassing the peak of the gain band of gain medium 30. The structure and operation of comb filter 44 and bandpass filter 46 may be based, for example, on the components of the comb laser described in U.S. Patent Application 18/366,705, filed August 8, 2023, whose disclosure is incorporated herein by reference. Alternatively, tunable output reflectors of the sort described herein may be used to broaden the spectral range of other types of semiconductor lasers and cavity designs that are known in the art.

Fig. 2A is a schematic detail view of tunable reflector 50, in accordance with an embodiment of the invention. In this embodiment, reflector 50 comprises a thermally tunable MZI, comprising a pair of waveguides 52, 54 on substrate 40, with respective heaters 62, 64, comprising resistive traces on substrate 40. Waveguides 52 and 54 are coupled together at both their ends by directional couplers 56 and 58, and a termination loop 60 at the inner end of the MZI. The coupling coefficients of directional couplers 56 and 58 determine the relative amounts of laser energy that are split between waveguides 52 and 54 and thus set the base reflectance of reflector 50 (for example as described in the above-mentioned article by El Shamy et al.) At the outer end of the MZI, waveguide 52 is coupled to cavity 42, while waveguide 54 outputs the laser beam from the cavity.

To control the spectral reflectance of reflector 50, different electrical currents are applied via electrical terminals 66 on substrate 40 to heaters 62 and 64 (or current is applied to only one of the heaters). The temperature differential between waveguides 52 and 54 results in a difference in the effective optical lengths of the waveguides, which in turn tunes the phase difference between the optical waves that meet at directional couplers 56 and 58. This phase difference, which varies as a function of wavelength, controls the spectral reflectance of reflector 50, i.e., the ratio, at each wavelength within the gain band of laser device 20, between the energy output from waveguide 54 and the energy reflected back into cavity 42 via waveguide 52. This spectral reflectance can be tuned in amplitude and wavelength by varying the currents applied to heaters 62 and/or 64.

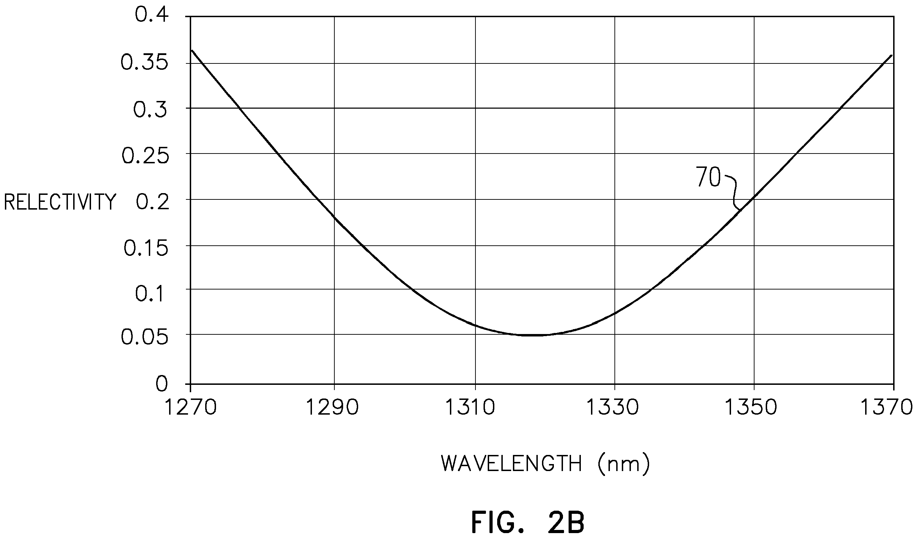

Fig. 2B is a schematic plot showing a reflectivity 70 of tunable reflector 50 as a function of wavelength, in accordance with an embodiment of the invention. In this example, the currents applied to heaters 62 and 64 are chosen to minimize the reflectivity at about 1320 nm, near the peak of the gain band of gain medium 30. The reflectivity is about 0.05 at the gain band peak and increases over a range of 50 nm on either side of this peak.

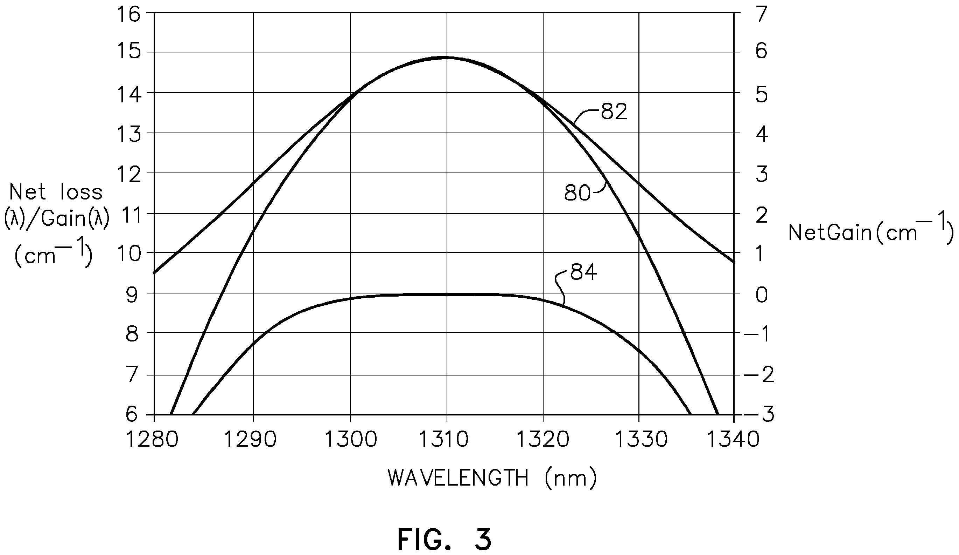

Fig. 3 is a plot that schematically shows spectral characteristics of laser device 20, in accordance with an embodiment of the invention. A curve 80 shows the gain of gain medium 30 as a function of wavelength (λ) in arbitrary units of inverse centimeters (cm-1). A curve 82 shows the net loss of the laser cavity as a function of wavelength in the same units as the gain. The net loss includes fixed losses, which are typically roughly constant as a function of wavelength, and the transmittance of reflector 50 (the inverse of the reflectance), which varies as a function of wavelength as illustrated in Fig. 2B.

The condition for lasing at a given wavelength X is that gain(λ) ≈ net loss(λ), meaning that the net gain (the difference between gain and net loss) is approximately zero. A curve 84 shows the net gain as a function of the wavelength. Because of the reduced reflectance of reflector 50 (illustrated by curve 82) at the peak of the gain band (illustrated by curve 80), the net gain has a broad, flat peak with a value of 0 cm-1, extending over the range from about 1300-1320 nm.

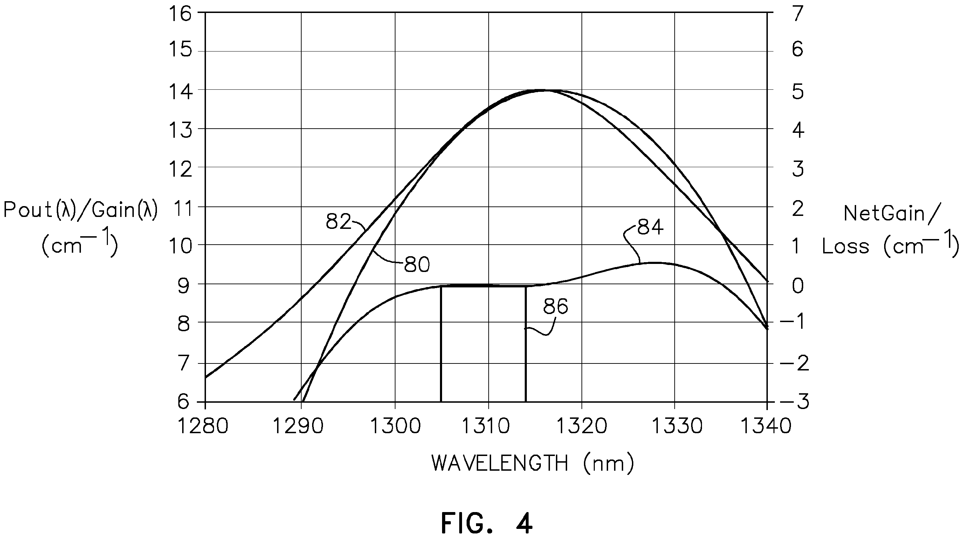

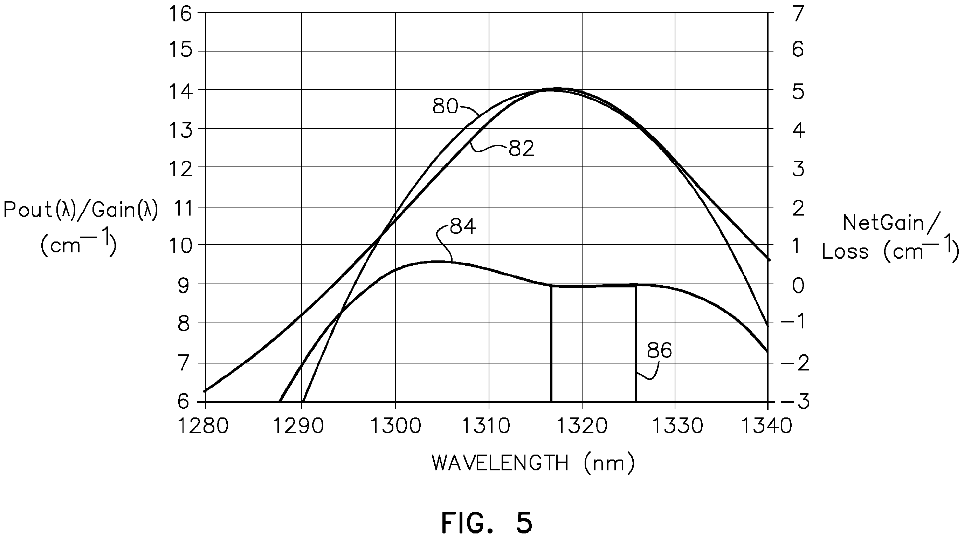

Figs. 4 and 5 are plots that schematically illustrate tuning of the spectral characteristics of laser device 20, in accordance with an embodiment of the invention. In both plots, a curve 86 shows the additional loss due to bandpass filter 46, which is tuned to select the operating wavelength range of the laser device. In Fig. 4, bandpass filter 46 and reflector 50 are tuned to shift the output wavelength range of laser device 20 to shorter wavelengths, in a range centered around 1309 nm; whereas in Fig. 5, the output wavelength range is centered around 1322 nm.

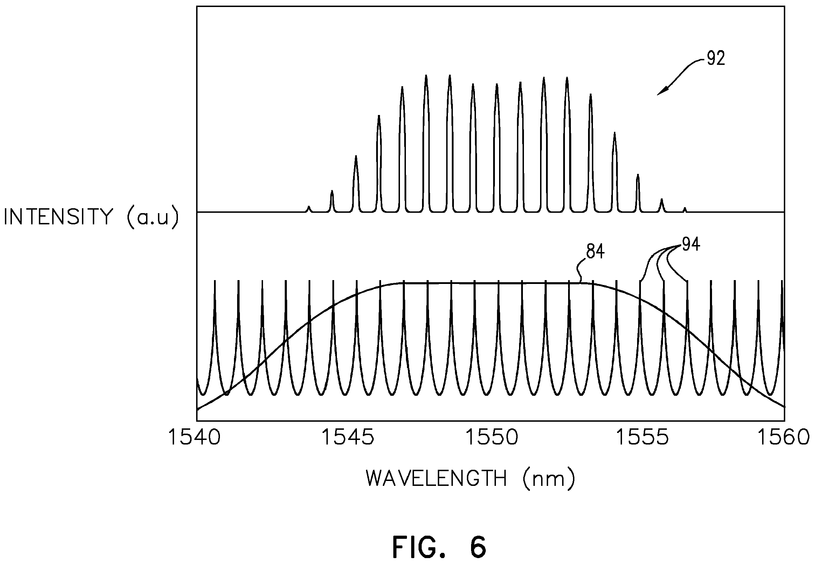

Fig. 6 is a plot that schematically shows an output spectrum of the laser device 20, in accordance with an embodiment of the invention. Curve 84 shows the net gain of the laser as a function of the wavelength, based on the curves shown in Fig. 3,, while a curve 94 shows the passband of comb filter 44 (Fig. 1). A curve 92 shows the resulting output spectrum of the laser device, producing a broad comb of distinct wavelength sub-bands 94 with approximately equal output power levels, spaced roughly 1 nm apart in wavelength. As noted earlier, the range of comb wavelengths may be shifted by appropriate tuning of bandpass filter 46 and reflector 50. Alternatively, the output characteristics of the laser device, such as the width of the emission band and the number of sub-bands in the comb, may be varied by appropriate changes to the laser cavity parameters.

The embodiments described above are cited by way of example, and the present invention is not limited to what has been particularly shown and described hereinabove. Rather, the scope of the present invention includes both combinations and subcombinations of the various features described hereinabove, as well as variations and modifications thereof which would occur to persons skilled in the art upon reading the foregoing description and which are not disclosed in the prior art.

### The following is a list of further preferred embodiments of the invention:

Embodiment 1. An optoelectronic device, comprising:
   a gain medium having first and second ends and configured to amplify laser radiation within a gain band having a peak at a given wavelength; and
   a laser cavity containing the gain medium and comprising:
      a first reflector disposed on a first side of the gain medium; and
      a second reflector disposed on a second side of the gain medium, opposite the first side, the second reflector having a reflectance as a function of wavelength that is tunable so as to reduce a reflectance of the second reflector at the peak of the gain band, thereby broadening a spectrum of the laser radiation emitted from the gain medium through the second reflector.
Embodiment 2. The device according to embodiment 1, and comprising a bandpass filter disposed within the laser cavity and having a passband encompassing the peak of the gain band.
Embodiment 3. The device according to embodiment 1, and comprising a comb filter disposed within the laser cavity and configured to pass a set of distinct wavelength sub-bands within the gain band, the set of distinct wavelength sub-bands defining a comb, wherein tuning the second reflector to reduce the reflectance increases a number of the wavelength sub-bands in the laser radiation that is emitted from the gain medium.
Embodiment 4. The device according to embodiment 3, wherein the comb filter comprises an optical ring resonator.
Embodiment 5. The device according to embodiment 1, wherein the second reflector comprises a tunable Mach-Zehnder interferometer (MZI).
Embodiment 6. The device according to embodiment 5, wherein the tunable MZI comprises a pair of waveguides disposed on a substrate and a heater disposed on the substrate and coupled to vary a temperature of at least one of the waveguides.
Embodiment 7. The device according to embodiment 1, wherein the gain medium and the first reflector are together comprised in a reflective semiconductor optical amplifier (RSOA), and the second reflector is comprised in an external laser cavity, which is disposed on an optical substrate and is optically coupled to the RSOA.
Embodiment 8. The device according to embodiment 7, wherein the RSOA comprises a III-V semiconductor material, and wherein the external laser cavity comprises a silicon photonic integrated circuit (PIC).
Embodiment 9. A method for generating radiation, the method comprising:
   providing a gain medium having first and second ends and configured to amplify laser radiation within a gain band having a peak at a given wavelength;
   inserting the gain medium in a laser cavity comprising a first reflector disposed on a first side of the gain medium and a second reflector disposed on a second side of the gain medium, opposite the first side, the second reflector having a reflectance that is tunable as a function of wavelength; and
   tuning the second reflector so as to reduce the reflectance at the peak of the gain band, thereby broadening a spectrum of the laser radiation emitted from the gain medium through the second reflector.
Embodiment 10. The method according to embodiment 9 and comprising inserting within the laser cavity a bandpass filter having a passband encompassing the peak of the gain band.
Embodiment 11. The method according to embodiment 9 and comprising inserting within the laser cavity a comb filter configured to pass a set of distinct wavelength sub-bands within the gain band, the set of distinct wavelength sub-bands defining a comb, wherein tuning the second reflector to reduce the reflectance increases a number of the wavelength sub-bands in the laser radiation that is emitted from the gain medium.
Embodiment 12. The method according to embodiment 11, wherein inserting the comb filter comprises coupling an optical ring resonator within the cavity.
Embodiment 13. The method according to embodiment 9, wherein inserting the gain medium comprises coupling a tunable Mach-Zehnder interferometer (MZI) to serve as the second reflector.
Embodiment 14. The method according to embodiment 13, wherein coupling the tunable MZI comprises providing a pair of waveguides and a heater on a substrate and wherein tuning the second reflector comprises controlling the heater to vary a temperature of at least one of the waveguides.
Embodiment 15. The method according to embodiment 9, wherein inserting the gain medium comprises providing a reflective semiconductor optical amplifier (RSOA) comprising the gain medium and the first reflector, and optically coupling an external laser cavity to the RSOA, wherein the external laser cavity is disposed on an optical substrate and comprises the second reflector.
Embodiment 16. The method according to embodiment 15, wherein providing the RSOA comprises forming the RSOA on a III-V semiconductor material, and wherein optically coupling the external laser cavity to the RSOA comprises coupling the RSOA via a waveguide to a silicon photonic integrated circuit (PIC).

## Claims

1. An optoelectronic device, comprising:
a gain medium having first and second ends and configured to amplify laser radiation within a gain band having a peak at a given wavelength; and
a laser cavity containing the gain medium and comprising:
a first reflector disposed on a first side of the gain medium; and
a second reflector disposed on a second side of the gain medium, opposite the first side, the second reflector having a reflectance as a function of wavelength that is tunable so as to reduce a reflectance of the second reflector at the peak of the gain band, thereby broadening a spectrum of the laser radiation emitted from the gain medium through the second reflector.

2. The device according to claim 1, and comprising a bandpass filter disposed within the laser cavity and having a passband encompassing the peak of the gain band.

3. The device according to claim 1, and comprising a comb filter disposed within the laser cavity and configured to pass a set of distinct wavelength sub-bands within the gain band, the set of distinct wavelength sub-bands defining a comb, wherein tuning the second reflector to reduce the reflectance increases a number of the wavelength sub-bands in the laser radiation that is emitted from the gain medium.

4. The device according to claim 3, wherein the comb filter comprises an optical ring resonator.

5. The device according to claim 1, wherein the second reflector comprises a tunable Mach-Zehnder interferometer (MZI).

6. The device according to claim 5, wherein the tunable MZI comprises a pair of waveguides disposed on a substrate and a heater disposed on the substrate and coupled to vary a temperature of at least one of the waveguides.

7. The device according to claim 1, wherein the gain medium and the first reflector are together comprised in a reflective semiconductor optical amplifier (RSOA), and the second reflector is comprised in an external laser cavity, which is disposed on an optical substrate and is optically coupled to the RSOA.

8. The device according to claim 7, wherein the RSOA comprises a III-V semiconductor material, and wherein the external laser cavity comprises a silicon photonic integrated circuit (PIC).

9. A method for generating radiation, the method comprising:
providing a gain medium having first and second ends and configured to amplify laser radiation within a gain band having a peak at a given wavelength;
inserting the gain medium in a laser cavity comprising a first reflector disposed on a first side of the gain medium and a second reflector disposed on a second side of the gain medium, opposite the first side, the second reflector having a reflectance that is tunable as a function of wavelength; and
tuning the second reflector so as to reduce the reflectance at the peak of the gain band, thereby broadening a spectrum of the laser radiation emitted from the gain medium through the second reflector.

10. The method according to claim 9 and comprising inserting within the laser cavity a bandpass filter having a passband encompassing the peak of the gain band.

11. The method according to claim 9 and comprising inserting within the laser cavity a comb filter configured to pass a set of distinct wavelength sub-bands within the gain band, the set of distinct wavelength sub-bands defining a comb, wherein tuning the second reflector to reduce the reflectance increases a number of the wavelength sub-bands in the laser radiation that is emitted from the gain medium.

12. The method according to claim 11, wherein inserting the comb filter comprises coupling an optical ring resonator within the cavity.

13. The method according to claim 9, wherein inserting the gain medium comprises coupling a tunable Mach-Zehnder interferometer (MZI) to serve as the second reflector.

14. The method according to claim 13, wherein coupling the tunable MZI comprises providing a pair of waveguides and a heater on a substrate and wherein tuning the second reflector comprises controlling the heater to vary a temperature of at least one of the waveguides.

15. The method according to claim 9, wherein inserting the gain medium comprises providing a reflective semiconductor optical amplifier (RSOA) comprising the gain medium and the first reflector, and optically coupling an external laser cavity to the RSOA, wherein the external laser cavity is disposed on an optical substrate and comprises the second reflector, and
wherein providing the RSOA comprises forming the RSOA on a III-V semiconductor material, and wherein optically coupling the external laser cavity to the RSOA comprises coupling the RSOA via a waveguide to a silicon photonic integrated circuit (PIC).
